# EUROPEAN PATENT APPLICATION

(11) **EP 4 510 801 A1**
(43) Date of publication of application: **19.02.2025**
(21) Application number: 23831761.4
(22) Date of filing: 09.06.2023
(51) Int. Cl.: H05K 9/00, H05K 7/20, C09K 5/14

(54) **SHIELDING STRUCTURE AND ELECTRONIC DEVICE INCLUDING SAME**

(30) Priority: 29.06.2022 KR 20220079918; 27.07.2022 KR 20220093080
(71) Applicant: Samsung Electronics Co., Ltd., Suwon-si, Gyeonggi-do 16677 (KR)
(72) Inventor: LEE, Muyeol, Suwon-si, Gyeonggi-do 16677 (KR); PARK, Eunsoo, Suwon-si, Gyeonggi-do 16677 (KR); LEE, Byungwoo, Suwon-si, Gyeonggi-do 16677 (KR); AN, Jinwan, Suwon-si, Gyeonggi-do 16677 (KR); LEE, Jiwoo, Suwon-si, Gyeonggi-do 16677 (KR); HAN, Yonggil, Suwon-si, Gyeonggi-do 16677 (KR)
(74) Representative: Nederlandsch Octrooibureau
(86) International application number: PCT/KR2023/007935
(87) International publication number: WO 2024/005401

(57) **Abstract**

An electronic device according to an embodiment of the present disclosure may comprise: a printed circuit board; an electronic component disposed on one surface of the printed circuit board; a shield frame disposed on the one surface of the printed circuit board while surrounding the electronic component, the shield frame comprising a frame opening; a shielding sheet disposed on one surface of the shield frame, and having at least a portion which is disposed in one direction of the frame opening of the shield frame to cover the frame opening; and a heat transfer material disposed between the electronic component and the shielding sheet. The shield frame comprises an opening side area comprising: a first surface in which the shielding sheet is disposed; and a second surface opposite the first surface. In relation to the opening side area, a first surface of the opening side area may be spaced apart from the electronic component by a first length, and a second surface of the opening side area may be spaced apart from the electronic component by a second length that is longer than the first length.

## Description

### [Technical Field]

The present disclosure relates to a shielding structure and an electronic device including the same.

### [Background Art]

An electronic device including an application processor may be designed with a structure that surrounds the application processor and major components with a shield frame to shield noise generated during operation of the application processor.

The electronic device including the application processor may have a hole machined in a portion of the shield frame and a heat transfer material applied to one surface of the application processor to prevent the temperature rise of the application processor. In addition, shielding tape may be attached to an upper portion of the heat transfer material to block noise generated during operation of the application processor while conducting heat generated from the application processor to the outside.

### [Disclosure of Invention]

### [Technical Problem]

An electronic device including an application processor may form a noise shielding structure in a manner of surrounding the application processor with a shield frame, applying a heat transfer material to an upper surface of the application processor and a portion where a hole in the shield frame is positioned, and then attaching and pressing a shielding tape thereon However, in small electronic devices such as a mobile phone, a space between the application processor and the shielding tape and a distance between the shield frame and the application processor may be formed narrow due to the limitation of disposition space. When a heat transfer material is disposed in the narrow space between the application processor and the shielding tape, the heat transfer material may be pressed by the shielding tape and invade an area between the shielding tape and the shield frame. When the heat transfer material infiltrates between the shielding tape and the shield frame, a gap may be created between the shielding tape and the shield frame, allowing noise generated from the application processor to escape to the outside.

In addition, the high heat generated by the operation of the application processor after the heat transfer material is applied may cause an oil component generated from the heat transfer material to invade the area between the shielding tape and the shield frame. When the oil component generated from the heat transfer material infiltrates between the shielding tape and the shield frame, the noise shielding performance of the shield frame may be degraded.

In the noise shielding structure, it may be difficult to increase the spacing distance between the application processor and the shield frame because the shield frame needs to maintain a minimum length to ensure the rigidity of the shield frame and the contact area of the shield frame and shielding tape. Therefore, there is need for a shielding structure that can prevent shielding power degradation while ensuring the rigidity of the shield frame and the contact area of the shield frame and shielding tape.

An electronic device according to an embodiment of the present disclosure may provide a shielding structure capable of preventing shielding power degradation between a shield frame and a shielding tape.

### [Solution to Problem]

There is provided an electronic device according to an embodiment of the present disclosure. The electronic device may include a printed circuit board, an electronic component disposed on one surface of the printed circuit board, a shield frame disposed on one surface of the printed circuit board and surrounding the electronic component, and including a frame opening formed in a position corresponding to the electronic component, a shielding sheet disposed on one surface of the shield frame, at least a portion of which is disposed in one direction of the frame opening of the shield frame to cover the frame opening, and a heat transfer material disposed between the electronic component and the shielding sheet, in which the shield frame may be formed on one side of the frame opening, and include an opening side area including a first surface on which the shielding sheet is disposed and a second surface opposite the first surface, and in the opening side area, the first surface of the opening side area may be spaced apart from the electronic component by a first length in a length direction of the electronic device, and the second surface of the opening side area may be spaced apart from the electronic component by a second length that is longer than the first length in a length direction of the electronic device.

A shielding structure according to an embodiment of the present disclosure may include a shield frame including a frame opening, and a shielding sheet disposed on one surface of the shield frame, at least a portion of which is disposed in one direction of the frame opening of the shield frame to cover the frame opening, in which the shield frame may include an opening side area formed on one side of the frame opening and including a first surface on which the shielding sheet is disposed and a second surface opposite the first surface, and in the opening side area, a first surface of the opening side area may extend longer toward the frame opening in a length direction of the shielding structure compared to the second surface of the opening side area.

### [Advantageous Effects of Invention]

A shielding structure according to an embodiment of the present disclosure and an electronic device including the same can further secure a spacing distance between an electronic component (e.g., an application processor) and a shield frame to prevent heat transfer material from invading an area between a shielding tape and the shield frame, thereby improving noise shielding performance degradation.

A shielding structure according to an embodiment of the present disclosure and an electronic device including the same include an exhaust opening in at least a portion of a shield frame, which can allow a heat transfer material to be easily discharged into the shield frame.

A shielding structure according to an embodiment of the present disclosure and an electronic device including the same include, at least in part, an absorbent pad capable of absorbing oil generated from a heat transfer material, which can improve noise shielding performance degradation due to the oil generated from the heat transfer material.

### [Brief Description of Drawings]

FIG. 1 is a block diagram of an electronic device in a network environment according to an embodiment.
FIG. 2 is a view illustrating an electronic device according to an embodiment of the present disclosure.
FIG. 3 is a view illustrating an opening side area of an electronic device and a shield frame according to an embodiment of the present disclosure.
FIG. 4 is a view illustrating a shield frame according to an embodiment of the present disclosure.
FIG. 5 is a view illustrating a shield frame in which an absorbent pad is disposed, according to an embodiment of the present disclosure.
FIG. 6 is a view illustrating a shield frame in which a shielding sheet is disposed, according to an embodiment of the present disclosure.
FIG. 7A, FIG. 7B, FIG. 7C, and FIG. 7D are views illustrating a heat transfer material disposed on an electronic component, according to an embodiment of the present disclosure.
FIG. 8 is a view illustrating a shield frame including a vertical surface, according to an embodiment of the present disclosure.
FIGS. 9A and 9B are views illustrating a shield frame including an exhaust opening, according to an embodiment of the present disclosure.
FIGS. 10A and 10B are views illustrating an insulating pad disposed inside a shield frame, according to an embodiment of the present disclosure.

### [Mode for the Invention]

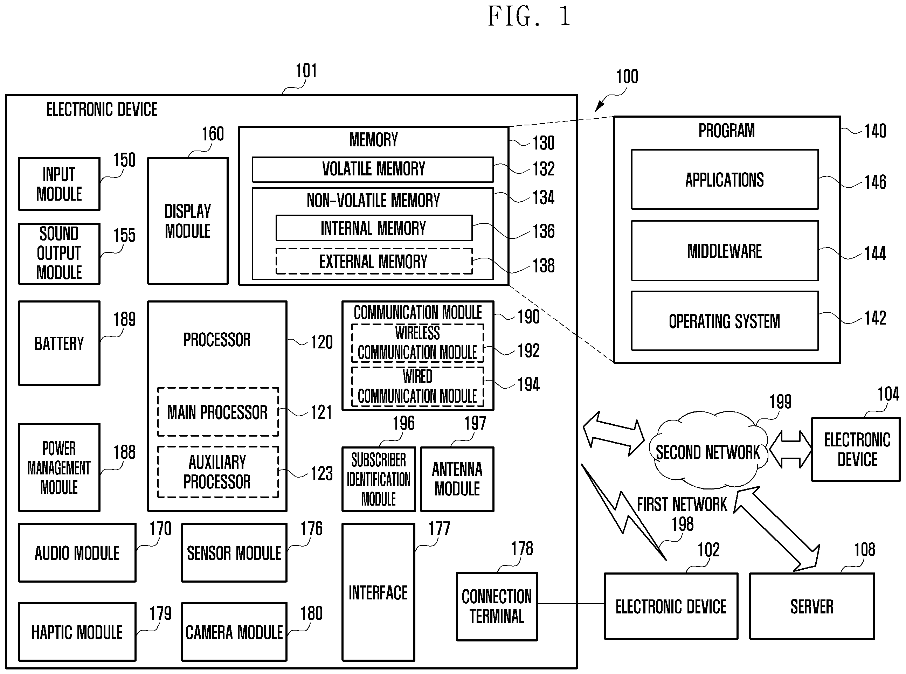

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

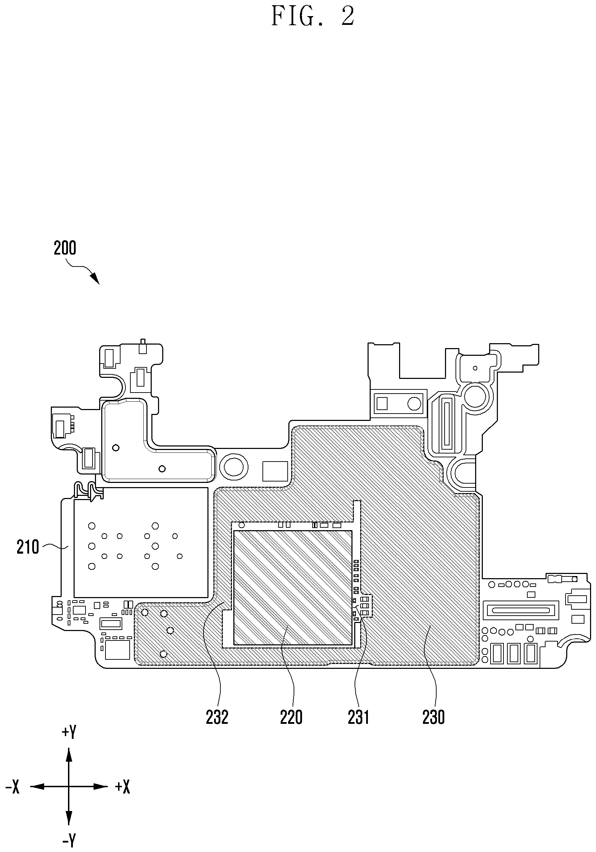

FIG. 2 is a view illustrating an electronic device 200 according to an embodiment of the present disclosure.

The electronic device 200 according to an embodiment of the present disclosure may be at least partially similar to the electronic device 101 in FIG. 1, or may further include other embodiments of the electronic device.

The electronic device 200 according to an embodiment of the present disclosure may include a printed circuit board 210, an electronic component 220, and/or a shield frame 230.

In describing the electronic device 200 according to an embodiment of the present disclosure, a length direction of the electronic device 200 may refer to an x-axis direction, and a width direction of the electronic device 200 may refer to a y-axis direction.

In an embodiment, the electronic component 220 and the shield frame 230 may be disposed on one surface of the printed circuit board 210.

In an embodiment, the electronic component 220 may include a processor (e.g., the processor 120 in FIG. 1), a communication module (e.g., the communication module 190 in FIG. 1), and/or a memory (e.g., the memory 130 in FIG. 1).

In an embodiment, the processor included in the electronic component 220 (e.g., the processor 120 in FIG. 1) may be an application processor.

In an embodiment, the shield frame 230 may be disposed on one surface of the printed circuit board 210 while surrounding the electronic component 220.

In an embodiment, the shield frame 230 may serve to shield noise generated from the electronic component 220. The noise from the electronic component 220 may cause electromagnetic interference (EMI) that degrades the radio frequency (RF) signal performance of the electronic device 200. The shield frame 230 may shield noise generated from the electronic component 220 to reduce electromagnetic interference caused by the noise.

In an embodiment, the shield frame 230 may include a metallic material with a high thermal conductivity to easily conduct heat generated from the electronic component 220 to the outside. For example, the shield frame 230 may include at least one of steel, stainless steel, or a copper alloy.

In an embodiment, the shield frame 230 may serve to protect the electronic component 220 from an externally applied impact.

In an embodiment, the shield frame 230 may be a shield can that is formed to have a predetermined thickness. The shield frame 230 may be formed to have a thickness of approximately 0.15 mm.

In an embodiment, the shield frame 230 may include a frame opening 231 at least in part. The frame opening 231 may be formed at a position corresponding to a position at which the electronic component 220 is disposed. For example, at least a portion of the frame opening 231 may be formed at the same position as a position at which the electronic component 220 is disposed with respect to a width direction (e.g., y-axis direction) and a length direction (e.g., x-axis direction) of the electronic device 200.

With reference to FIG. 2, the electronic device 200 is illustrated as including one electronic component 220, but the electronic device 200 may include a plurality of electronic components 220. When the electronic device 200 includes a plurality of electronic components 220, the plurality of electronic components 220 may be disposed at a position corresponding to the frame opening 231.

In an embodiment, a length of the frame opening 231 or a length of the electronic component 220 may mean a length that the frame opening 231 or the electronic component 220 extends in a predetermined direction. For example, the length of the frame opening 231 may include a length by which the frame opening 231 extends in a length direction of the electronic device 200 (e.g., x-axis direction) or a length by which the frame opening 231 extends in a width direction of the electronic device 200 (e.g., y-axis direction). The length of the electronic component 220 may include a length by which the electronic component 220 extends in a length direction of the electronic device 200 (e.g., x-axis direction) or a length by which the electronic component 220 extends in a width direction of the electronic device 200 (e.g., y-axis direction).

With reference to FIG. 2, the length of the frame opening 231 may be formed to be longer than the length of the electronic component 220. For example, the length by which the frame opening 231 extends in the x-axis direction or the y-axis direction may be formed to be longer than the length by which the electronic component 220 extends in the x-axis direction or the y-axis direction.

In FIG. 2, the length of the frame opening 231 is illustrated as being formed longer than the length of the electronic component 220, but this is exemplary and the length of the frame opening 231 may be formed shorter than the length of the electronic component 220. For example, the length of the frame opening 231 in the x-axis direction may be formed shorter than the length of the electronic component 220 in the x-axis direction, or the length of the frame opening 231 in the y-axis direction may be formed shorter than the length of the electronic component 220 in the y-axis direction.

In an embodiment, when the length of the frame opening 231 is formed to be shorter than the length of the electronic component 220, only a portion of the electronic component 220 may be disposed at a position that overlaps the frame opening 231, and a remaining portion of the electronic component 220 may be disposed at a position that overlaps a position at which the shield frame 230, excluding the frame opening 231, is formed, with respect to a position on the x-y plane.

In an embodiment, the frame opening 231 of the shield frame 230 may serve to prevent the temperature inside the shield frame 230 from rising rapidly due to heat generated by the electronic component 220.

In an embodiment, the shield frame 230 may include an opening side area 232. The opening side area 232 is formed on one side of the frame opening 231, and may be an area positioned closer to the electronic component 220 in the width direction (e.g., y-axis direction) or length direction (e.g., x-axis direction) of the electronic device 200 compared to other areas of the shield frame 230. For example, with reference to FIG. 2, the opening side area 232 may be formed in an area of the shield frame 230 positioned in the negative x-axis direction with respect to the frame opening 231. The opening side area 232 may be positioned closer to the electronic component 220 in the length direction (e.g., x-axis direction) of the electronic device 200 than other areas of the shield frame 230 positioned in the positive x-axis direction or the positive y-axis direction with respect to the frame opening 231.

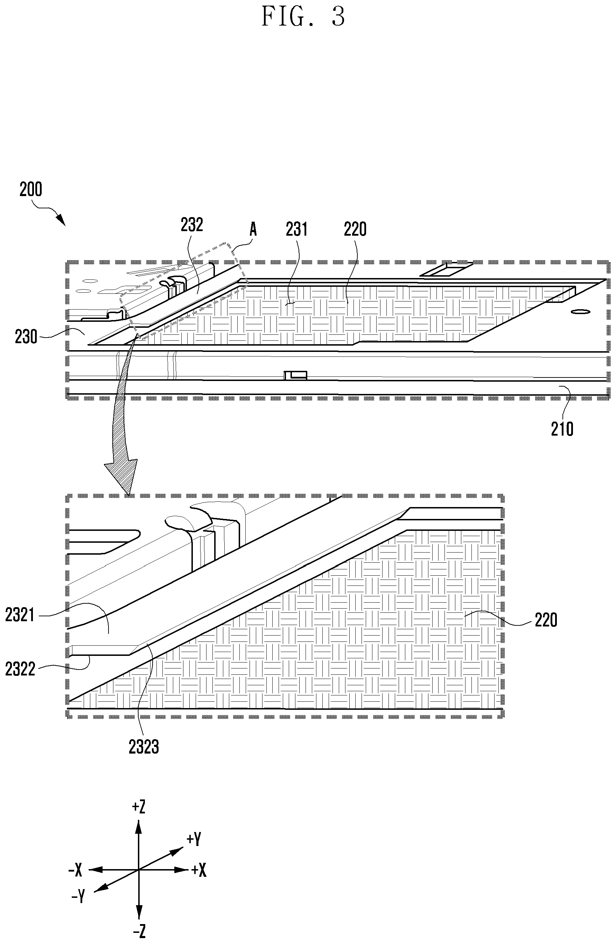

FIG. 3 is a view illustrating the electronic device 200 and the opening side area 232 of the shield frame 230 according to an embodiment of the present disclosure.

With reference to FIG. 3, in describing the electronic device 200 according to an embodiment of the present disclosure, a height direction of the electronic device 200 may mean the z-axis direction.

In an embodiment, the shield frame 230 may include the opening side area 232 at least in part. Area A, illustrated in FIG. 3, illustrates an enlarged view of the opening side area 232 of the shield frame 230.

In an embodiment, the opening side area 232 may mean an area of the shield frame 230 that is formed on one side of the frame opening 231. For example, in an embodiment, the opening side area 232 may be an area positioned in the negative x-axis direction with respect to the frame opening 231.

Although the opening side area 232 is illustrated in FIG. 3 as being positioned in the negative x-axis direction with respect to the frame opening 231, the position of the opening side area 232 may not be limited thereto. For example, the opening side area 232 may be disposed on a portion of the shield frame 230 positioned in the positive x-axis direction, as well as the negative x-axis direction, or the positive or negative y-axis direction, centered on the frame opening 231.

In an embodiment, the opening side area 232 may include a first surface 2321, a second surface 2322, and/or an inclined surface 2323. The first surface 2321 of the opening side area 232 may mean a surface facing vertically in a direction away from the printed circuit board 210. For example, with reference to FIG. 3, the first surface 2321 may be a surface facing vertically in the positive z-axis direction in the opening side area 232.

In an embodiment, the second surface 2322 of the opening side area 232 may mean a surface facing in an opposite direction of the first surface 2321. For example, the second surface 2322 may be a surface facing in a direction toward the printed circuit board 210. With reference to FIG. 3, the second surface 2322 may be a surface facing vertically in the negative z-axis direction in the opening side area 232.

In an embodiment, the first surface 2321 of the opening side area 232 may extend longer toward the frame opening 231 in the length direction (e.g., x-axis direction) of the electronic device 200 compared to the second surface 2322 of the opening side area 232.

In an embodiment, the inclined surface 2323 of the opening side area 232 may mean a surface connecting the first surface 2321 and the second surface 2322. For example, the inclined surface 2323 of the opening side area 232 may be connected to the first surface 2321 at one end (e.g., an end positioned in the positive z-axis direction with respect to the inclined surface 2323) and connected to the second surface 2322 at the other end (e.g., an end positioned in the negative z-axis direction with respect to the inclined surface 2323).

In an embodiment, the inclined surface 2323 of the opening side area 232 may be a surface that is formed with at least a portion thereof inclined in a direction toward the electronic component 220 with respect to the height direction of the electronic device 200. Alternatively, the inclined surface 2323 may be a surface formed with at least a portion thereof inclined in a direction closer to the frame opening 231 with respect to the height direction (e.g., z-axis direction) of the electronic device 200.

With reference to FIG. 3, the inclined surface 2323 of the opening side area 232 may be formed with a surface parallel to the height direction (e.g., z-axis direction) of the electronic device 200 and the width direction (e.g., y-axis direction) of the electronic device 200 inclined by a predetermined angle toward the length direction (e.g., x-axis direction) of the electronic device 200.

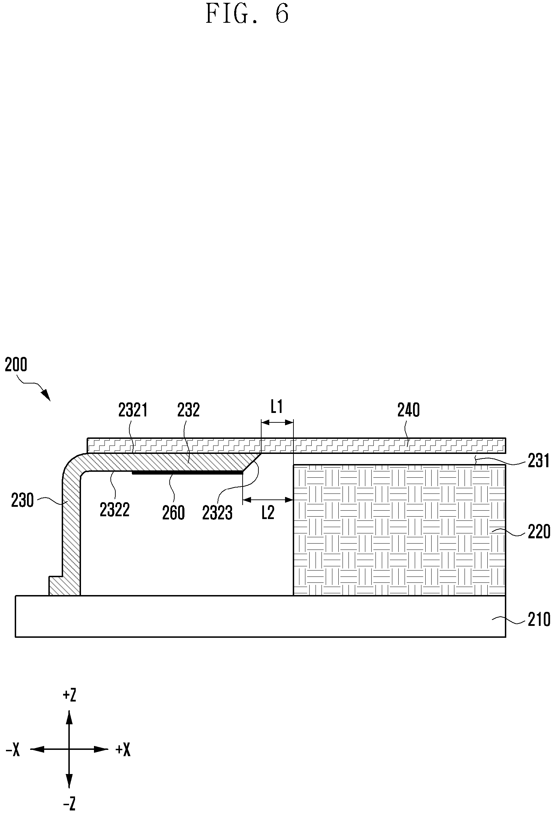

With reference to FIG. 3, the inclined surface 2323 is illustrated as being formed in one direction (e.g., negative x-axis direction) centered on the frame opening 231, but the position at which the inclined surface 2323 is formed may not be limited thereto. For example, the inclined surface 2323 may be formed on a portion of the shield frame 230 positioned in the positive x-axis direction, and in the positive or negative y-axis direction, centered on the frame opening 231. Preferably, the inclined surface 2323 may be formed in an area of the shield frame 230 that surrounds the frame opening 231, where a surface area in contact with the shielding sheet 240 (see FIG. 6) is formed relatively small.

With reference to FIG. 3, one inclined surface 2323 is illustrated as being formed on a portion of the shield frame 230, but a plurality of inclined surfaces 2323 may each be formed on an area of the shield frame 230 that surrounds the frame opening 231. For example, the plurality of inclined surface 2323 may each be formed on a portion of the shield frame 230 positioned in the positive x-axis direction, and in the positive or negative y-axis direction, centered on the frame opening 231.

In an embodiment, the inclined surface 2323 of the shield frame 230 may be formed by machining the shield frame 230 in a separate process after the shield frame 230 is manufactured. Alternatively, the inclined surface 2323 of the shield frame 230 may be formed in such a way that a chamfer is applied to a portion in which the inclined surface 2323 is required in a mold for manufacturing the shield frame 230.

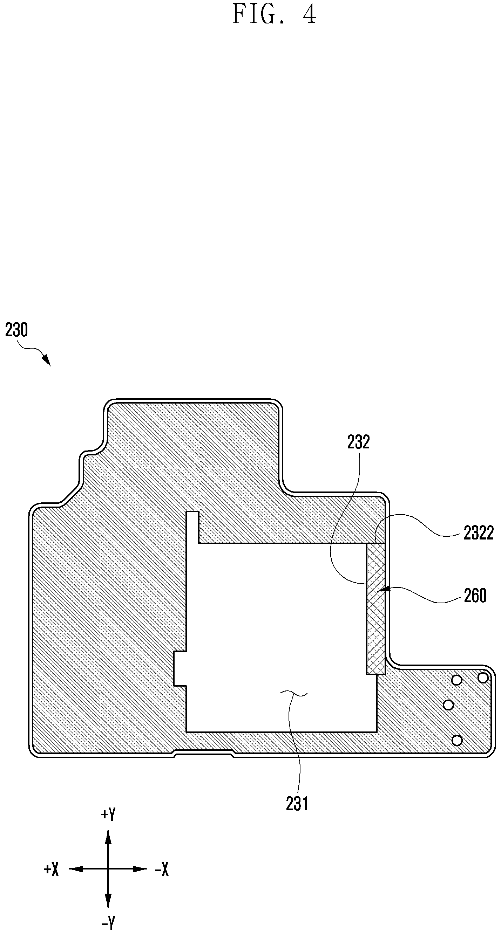

FIG. 4 is a view illustrating the shield frame 230 according to an embodiment of the present disclosure.

FIG. 4 is a view illustrating a state of viewing the second surface 2322 of the opening side area 232 of the shield frame 230 according to an embodiment of the present disclosure.

In an embodiment, the shield frame 230 may include a frame opening 231 at least in part.

In an embodiment, the opening side area 232 may be positioned on one side of the frame opening 231. An absorbent pad 260 may be disposed on at least a portion of the opening side area 232. For example, the absorbent pad 260 may be disposed on the second surface 2322 of the opening side area 232.

Although the absorbent pad 260 is illustrated in FIG. 4 as being disposed in the opening side area 232, the position at which the absorbent pad 260 is disposed may not be limited thereto. For example, the absorbent pad 260 may be disposed on a portion of the shield frame 230 positioned in the positive x-axis direction, as well as the negative x-axis direction, or the positive or negative y-axis direction, centered on the frame opening 231.

In an embodiment, the absorbent pad 260 may be formed to extend in the length direction (e.g., x-axis direction) and width direction (e.g., y-axis direction) of the electronic device 200.

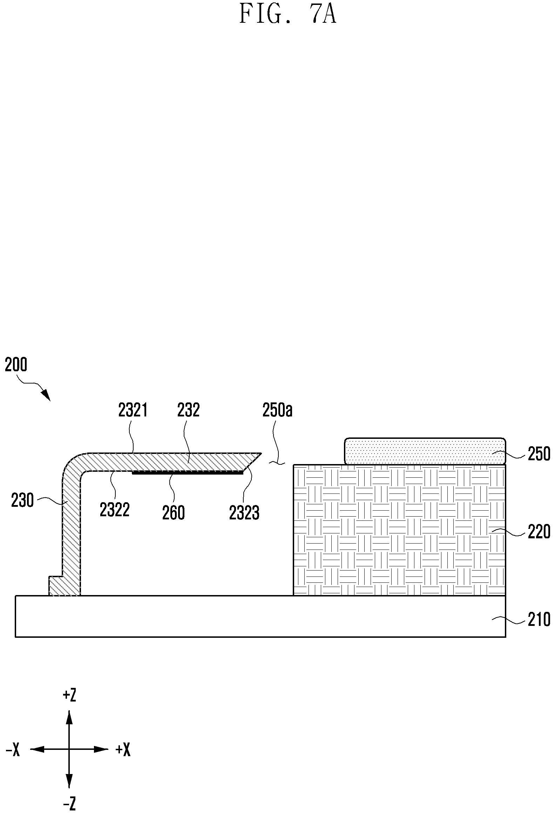

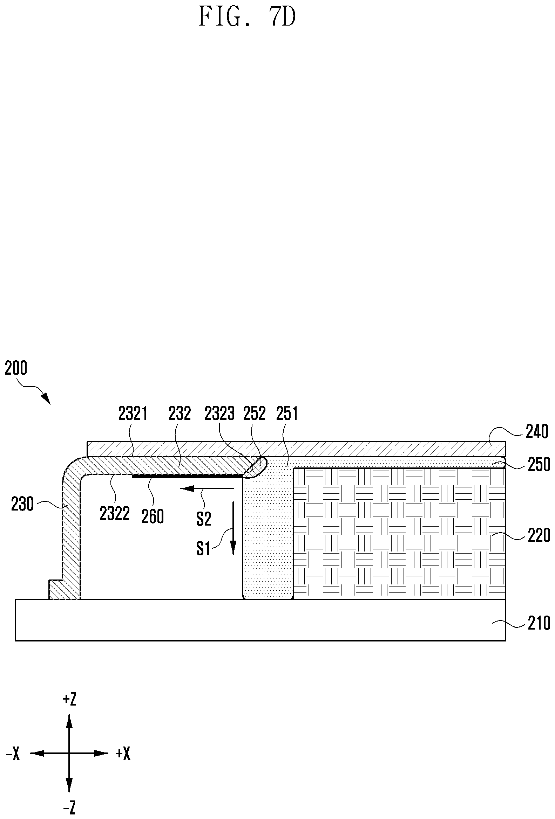

In an embodiment, the absorbent pad 260 may include a non-conductive material and/or a material capable of absorbing oil. The absorbent pad 260 may serve to absorb an oil material 252 (see FIG. 7D) generated from a heat transfer material 250 (see FIG. 7A).

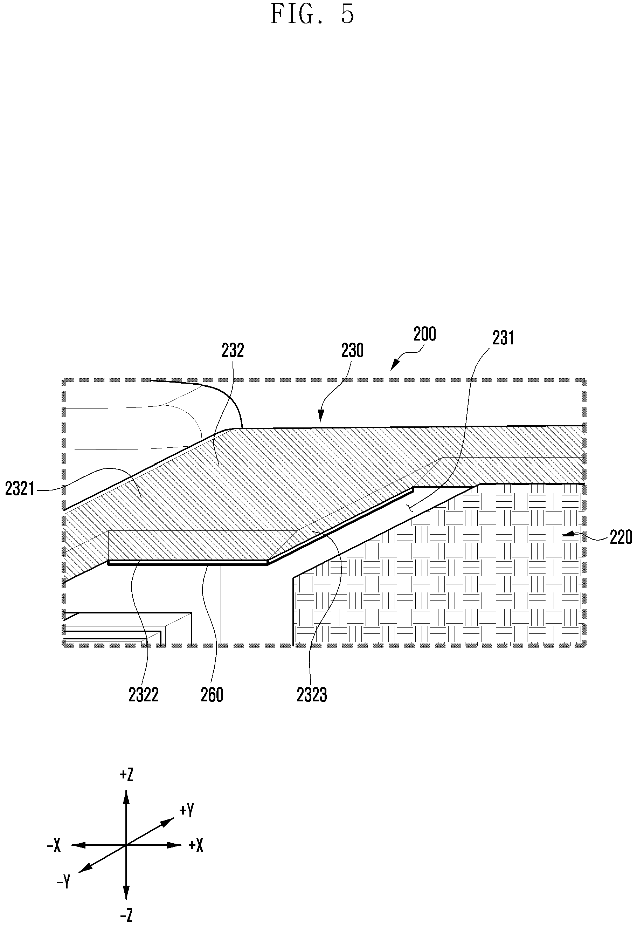

FIG. 5 is a view illustrating the shield frame 230 in which the absorbent pad 260 is disposed, according to an embodiment of the present disclosure.

In an embodiment, the electronic device 200 may include the absorbent pad 260. The absorbent pad 260 may be disposed on at least a portion of the shield frame 230. For example, the absorbent pad 260 may be disposed on the second surface 2322 of the opening side area 232 of the shield frame 230.

Although the absorbent pad 260 is illustrated in FIG. 5 as being disposed across the entire second surface 2322 of the opening side area 232, the disposition of the absorbent pad 260 is not limited thereto. For example, the absorbent pad 260 may be disposed on only a portion of the second surface 2322.

With reference to FIG. 5, the absorbent pad 260 may be formed as a plate shape that extends in the length direction (e.g., x-axis direction) and width direction (e.g., y-axis direction) of the electronic device 200 and has a thickness in the height direction (e.g., z-axis direction) of the electronic device 200.

In an embodiment, the opening side area 232 of the shield frame 230 may be positioned spaced apart from the electronic component 220 at a predetermined spacing. The first surface 2321, the second surface 2322, and the inclined surface 2323 of the opening side area 232 may be positioned spaced apart from the electronic component 220 in the length direction (e.g., x-axis direction) of the electronic device 200. For example, an end of the first surface 2321 positioned closest to the frame opening 231 in the first surface 2321 of the opening side area 232 may be positioned spaced apart from an end of the electronic component 220 (e.g., an end of the electronic component 220 positioned relatively close to the opening side area 232) in the length direction of the electronic device 200.

FIG. 6 is a view illustrating the shield frame 230 in which the shielding sheet 240 is disposed, according to an embodiment of the present disclosure.

A shielding structure, according to an embodiment of the present disclosure, may mean a structure including the shield frame 230, the shielding sheet 240, and/or the absorbent pad 260.

In an embodiment, a length direction and a height direction of the shielding structure may mean the same direction as the length direction and the height direction of the electronic device 200, respectively. For example, the length direction of the shielding structure may mean the x-axis direction, and the height direction may mean the z-axis direction. A width direction of the shielding structure may mean a direction perpendicular to the x-axis direction and the z-axis direction.

In an embodiment, the shielding sheet 240 may be disposed at least a portion of the shield frame 230. For example, the shielding sheet 240 may have at least a portion disposed on the first surface 2321 of the opening side area 232 of the shield frame 230.

In one embodiment, the opening side area 232 may be an area of the shield frame 230 positioned around the circumference of the frame opening 231, where a surface area in contact with the shielding sheet 240 is formed relatively small. In an embodiment, at least a portion of the shielding sheet 240 may be disposed to cover the frame opening 231 of the shield frame 230. For example, the shielding sheet 240 may be disposed in the positive z-axis direction with respect to the frame opening 231 to cover the frame opening 231.

In an embodiment, the shielding sheet 240 may be positioned spaced apart from the electronic component 220 in the height direction (e.g., z-axis direction) of the electronic device 200. For example, the shielding sheet 240 may be positioned spaced apart with respect to the electronic component 220 in the positive z-axis direction.

In an embodiment, the shielding sheet 240 may include an adhesive material. For example, the shielding sheet 240 may include an adhesive layer that has an adhesive force. Alternatively, the shielding sheet 240 may include a tape with an adhesive property. A portion of the shielding sheet 240 including an adhesive material may be adhered to the first surface 2321 of the opening side area 232.

In an embodiment, at least a portion of the shield frame 230 may be disposed spaced apart from the electronic component 220. For example, the first surface 2321 of the opening side area 232 of the shield frame 230 may be positioned spaced apart from the electronic component 220 by a first length L1 in the length direction (e.g., x-axis direction) of the electronic device 200. The second surface 2322 of the opening side area 232 of the shield frame 230 may be positioned spaced apart from the electronic component 220 by a second length L2 in the length direction (e.g., x-axis direction) of the electronic device 200.

In an embodiment, the inclined surface 2323 of the shield frame 230 may be a surface that is inclined toward the length direction (e.g., x-axis direction) of the electronic device 200 with respect to the height direction (e.g., z-axis direction) of the electronic device 200.

In an embodiment, the second length L2 may be formed longer than the first length L1. For example, when an angle at which the inclined surface 2323 of the shield frame 230 is inclined toward the length direction (e.g., x-axis direction) with respect to the height direction (e.g., z-axis direction) of the electronic device 200 is 45 degrees, the first length L1 may be formed to be approximately 0.25 mm, and the second length L2 may be formed to be approximately 0.4 mm.

In an embodiment, the angle at which the inclined surface 2323 of the shield frame 230 is inclined toward the length direction (e.g., x-axis direction) of the electronic device 200 with respect to the height direction (e.g., z-axis direction) of the electronic device 200 may be determined on the basis of a distance between the electronic component 220 and the shield frame 230, a thickness of the shield frame 230, and an amount of heat transfer material 250 (see FIG. 7A) disposed on the electronic component 220.

In an embodiment, the inclined surface 2323 of the shield frame 230 may be positioned spaced apart from the electronic component 220 in the length direction (e.g., x-axis direction) of the electronic device 200. For example, the inclined surface 2323 may be positioned spaced apart from the electronic component 220 by a length that is equal to or greater than the first length L1 and equal to or less than the second length L2 in the length direction (e.g., x-axis direction) of the electronic device 200.

With reference to FIG. 6, an angle at which the inclined surface 2323 of the shield frame 230 is inclined with respect to the height direction (e.g., z-axis direction) of the electronic device 200 is illustrated as being constant along the inclined surface 2323 of the shield frame 230, but the angle at which the inclined surface 2323 of the shield frame 230 is inclined may not be limited to one angle. For example, the angle at which the inclined surface 2323 of the shield frame 230 is inclined may vary along the inclined surface 2323.

In an embodiment, the absorbent pad 260 may be disposed on the second surface 2322 of the opening side area 232 of the shield frame 230. The absorbent pad 260 may be disposed spaced apart from the electronic component 220 by the second length L2 with respect to the length direction (e.g., x-axis direction) of the electronic device 200.

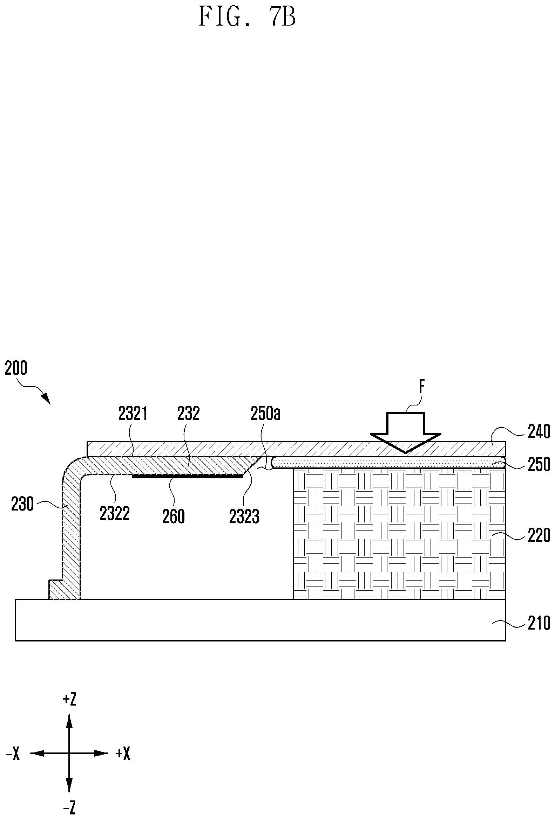

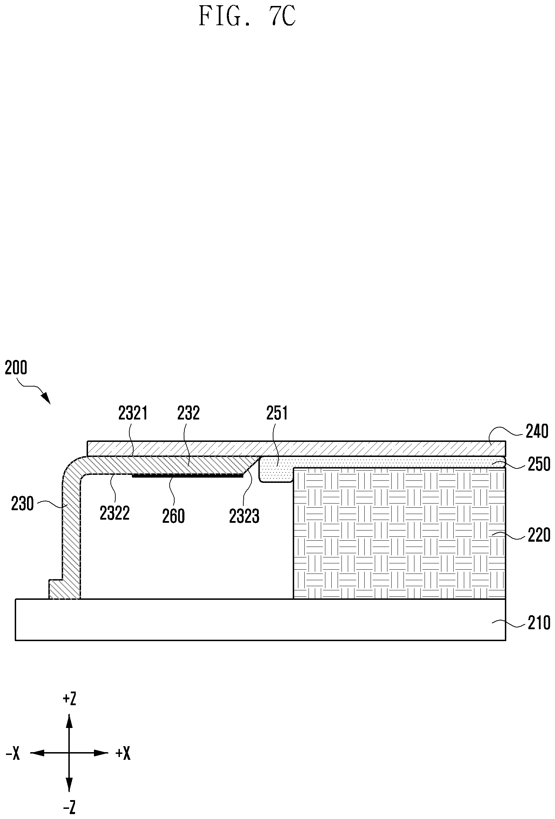

FIG. 7A, FIG. 7B, FIG. 7C, and FIG. 7D are views illustrating the heat transfer material 250 disposed on the electronic component 220, according to an embodiment of the present disclosure.

In an embodiment, the electronic device 200 may include the heat transfer material 250. The heat transfer material 250 may serve to mediate heat generated from the electronic component 220 to be conducted. For example, the heat generated by the electronic component 220 may be transferred to the shielding sheet 240 through the heat transfer material 250.

In an embodiment, the shielding sheet 240 may include a heat transfer material. The heat transferred to the shielding sheet 240 through the heat transfer material 250 may be transferred to the outside of the shield frame 230 through the heat transfer material included in the shielding sheet 240.

In an embodiment, the heat transfer material 250 may include a solid material and/or a liquid material. For example, the heat transfer material 250 may include a gel thermal interface material (GEL TIM).

With reference to FIGS. 7A, 7B, 7C, and 7D, the heat transfer material 250 may be disposed on one surface of the electronic component 220. For example, at least a portion of the heat transfer material 250 may be disposed on a surface of the electronic component 220 facing in the positive z-axis direction.

In an embodiment, a first direction of the heat transfer material 250 may mean a direction toward the positive z-axis with respect to the heat transfer material 250, and a second direction of the heat transfer material 250 may mean a direction toward the negative z-axis with respect to the heat transfer material 250.

With reference to FIG. 7A, a spacing space 250a may be formed between the shield frame 230 and the heat transfer material 250. For example, before the shielding sheet 240 is disposed on the heat transfer material 250, the shield frame 230 and the heat transfer material 250 may be disposed spaced apart from each other to form the spacing space 250a.

With reference to FIG. 7B, the heat transfer material 250 may be disposed between the shielding sheet 240 and the electronic component 220. For example, the shielding sheet 240 may be disposed in the first direction of the heat transfer material 250 and the electronic component 220 may be disposed in the second direction of the heat transfer material 250, centered on the heat transfer material 250.

In an embodiment, the shielding sheet 240 may be disposed on the heat transfer material 250 and the shield frame 230. For example, the shielding sheet 240 may be disposed in the first direction of the heat transfer material 250 to be in contact with the heat transfer material 250. The shielding sheet 240 may be disposed, at least in part, on the first surface 2321 of the opening side area 232 of the shield frame 230. At least a portion of the shielding sheet 240 may be adhered to the first surface 2321 of the opening side area 232.

With reference to FIG. 7B, after the shielding sheet 240 is disposed on the heat transfer material 250 and the shield frame 230, the heat transfer material 250 disposed on one surface of the electronic component 220 may be pressed in the height direction (e.g., z-axis direction) of the electronic device 200.

In an embodiment, the shape of the heat transfer material 250 may vary. For example, the heat transfer material 250 may include viscous, spreadable, and flowable materials so that the shape of the material may vary while spreading or flowing in response to an externally applied force.

With reference to FIG. 7B, a force F may be applied from the outside of the shielding sheet 240 in a direction in which the shielding sheet 240 is closer to the electronic component 220 (e.g., negative z-axis direction) in order for at least a portion of the shielding sheet 240 to be adhered to at least a portion of the shield frame 230.

In an embodiment, the force F applied to the shielding sheet 240 may be transmitted to the heat transfer material 250. With reference to FIG. 7B, the shape of the heat transfer material 250 may vary as the heat transfer material 250 is subjected to the force. For example, the heat transfer material 250 may be subjected to a force that causes at least a portion of the heat transfer material 250 to spread in the length direction and width direction of the electronic device 200. While the heat transfer material 250 spreads in the length direction and width direction of the electronic device 200, a thickness of the heat transfer material 250 (e.g., a length of the heat transfer material 250 in the z-axis direction) may become thinner and a length of the heat transfer material 250 (e.g., a length of the heat transfer material 250 in the x-axis direction) may become relatively longer.

With reference to FIG. 7B, the shielding sheet 240 is disposed in the first direction of the heat transfer material 250, and a height (e.g., a length in the z-axis direction) of the heat transfer material 250 may be limited. As the shielding sheet 240 is disposed in the first direction of the heat transfer material 250, at least a portion of the heat transfer material 250 may be moved toward the length direction (e.g., x-axis direction) of the electronic device 200.

With reference to FIGS. 7B, 7C, and 7D, the shielding sheet 240 may be disposed on the heat transfer material 250 to press the heat transfer material 250, thereby causing at least a portion of the heat transfer material 250 to move to the spacing space 250a.

With reference to FIGS. 7B, 7C, and 7D, a portion of the heat transfer material 250 disposed in the spacing space 250a may be defined as a diffusion area 251 of the heat transfer material 250.

With reference to FIGS. 7B and 7C, the diffusion area 251 of the heat transfer material 250 may be moved toward the spacing space 250a in the length direction (e.g., negative x-axis direction) of the electronic device 200.

With reference to FIG. 7C, the diffusion area 251 of the heat transfer material 250 may be in contact with a portion of the shield frame 230. For example, the diffusion area 251 of the heat transfer material 250 may be in contact with the first surface 2321 of the opening side area 232 of the shield frame 230 that is positioned closest to the heat transfer material 250 of a portion of the shield frame 230.

In an embodiment, the inclined surface 2323 of the shield frame 230 may serve to guide the heat transfer material 250 to flow in a direction toward the printed circuit board 210 (e.g., negative z-axis direction).

With reference to FIGS. 7C and 7D, the diffusion area 251 of the heat transfer material 250 may be moved in a direction toward the printed circuit board 210 (e.g., negative z-axis direction). For example, the diffusion area 251 of the heat transfer material 250 is prevented by the shield frame 230 and the shielding sheet 240 from being moved in the negative x-axis direction, and may be moved in a direction toward the printed circuit board 210.

In an embodiment, the diffusion area 251 of the heat transfer material 250 may be moved in the negative z-axis direction along a first diffusion path S1. The diffusion area 251 of the heat transfer material 250 may be moved along the first diffusion path S1 to come into contact with the printed circuit board 210.

In an embodiment, after the heat transfer material 250 is disposed on one surface of the electronic component 220, the oil material 252 included in the heat transfer material 250 may flow out of the heat transfer material 250. The oil material 252 may be a material that flows from the heat transfer material 250 due to the high temperature heat generated from the electronic component 220.

With reference to FIG. 7D, the oil material 252 included in the heat transfer material 250 may flow in a direction toward the shield frame 230 (e.g., negative x-axis direction).

In an embodiment, the inclined surface 2323 of the shield frame 230 may serve to guide a movement path of the oil material 252 so that the oil material 252 generated from the heat transfer material 250 is moved in a direction toward the absorbent pad 260.

In an embodiment, at least a portion of the oil material 252 that flows in a direction toward the shield frame 230 (e.g., negative x-axis direction) may be absorbed by the absorbent pad 260 disposed on the shield frame 230. For example, with reference to FIG. 7D, the oil material 252 discharged from the heat transfer material 250 may move along the second diffusion path S2 and be absorbed into the absorbent pad 260.

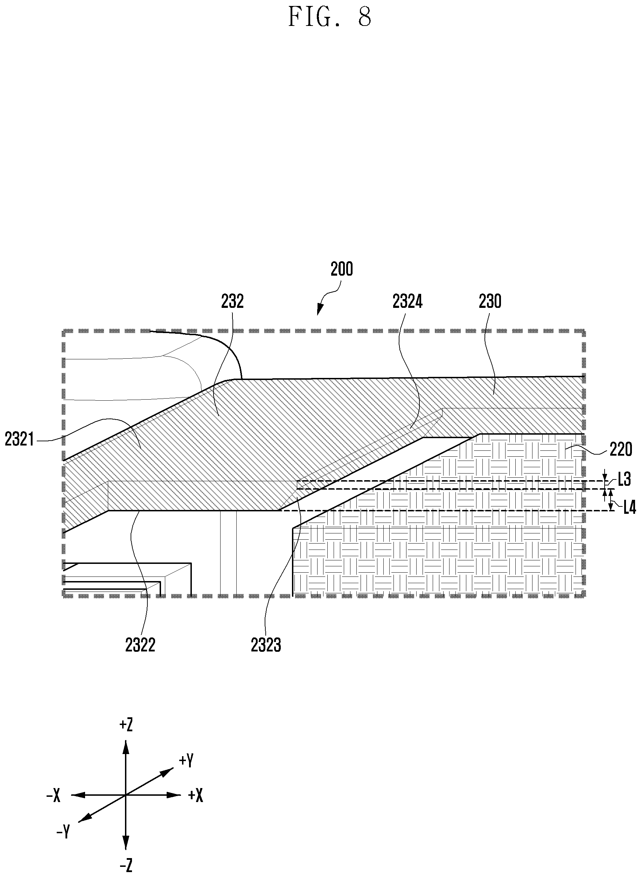

FIG. 8 is a view illustrating the shield frame 230 including a vertical surface 2324, according to an embodiment of the present disclosure.

In an embodiment, the shield frame 230 may include, at least in part, the vertical surface 2324. For example, the opening side area 232 of the shield frame 230 may include, at least in part, the vertical surface 2324.

In an embodiment, the vertical surface 2324 may mean a surface that is parallel to the height direction (e.g., z-axis direction) of the electronic device 200 in a portion of the opening side area 232 and perpendicular to the length direction (e.g., x-axis direction) of the electronic device 200. The vertical surface 2324 may mean a surface formed perpendicular to a direction in which the heat transfer material 250 (see FIG. 7D) flows (e.g., x-axis direction).

The vertical surface 2324, according to an embodiment, may be connected to the first surface 2321 and the inclined surface 2323 of the opening side area 232. For example, the vertical surface 2324 may be connected to the first surface 2321 at one end (e.g., an end of the vertical surface 2324 that is toward the positive z-axis direction) and connected to the inclined surface 2323 at the other end (e.g., an end of the vertical surface 2324 that is toward the negative z-axis direction). When the opening side area 232 includes the vertical surface 2324, the inclined surface 2323 may be connected to the vertical surface 2324 at one end and connected to the second surface 2322 of the opening side area 232 at the other end.

The vertical surface 2324, according to an embodiment, may extend in the height direction (e.g., z-axis direction) of the electronic device 200 by a third length L3. The inclined surface 2323 of the opening side area 232 may extend in the height direction of the electronic device 200 by a fourth length L4.

With reference to FIG. 8, in an embodiment, the third length L3 may be formed shorter than the fourth length L4, but the relative length relationship between the third length L3 and the fourth length L4 may not be limited thereto. For example, in other embodiments, the third length L3 may be formed longer than the fourth length L4.

In an embodiment, the vertical surface 2324 of the shield frame 230 may serve to prevent the heat transfer material 250 (see FIG. 7D) from moving between the shielding sheet 240 (see FIG. 7D) and the shield frame 230. For example, movement of the heat transfer material 250 (see FIG. 7D) toward the negative x-axis direction may be blocked by the vertical surface 2324 formed perpendicular to the negative x-axis direction, thereby preventing the heat transfer material 250 (see FIG. 7D) from moving between the shielding sheet 240 (see FIG. 7D) and the shield frame 230.

In an embodiment, when the vertical surface 2324 is formed on a portion of the shield frame 230, the inclined surface 2323 of the shield frame 230 may not protrude sharply in one direction. The shield frame 230 including the vertical surface 2324 may have an effect of preventing the formation of sharp protrusions from the opening side area 232, thereby allowing the manufacturer of the electronic device 200 to safely handle the shield frame 230.

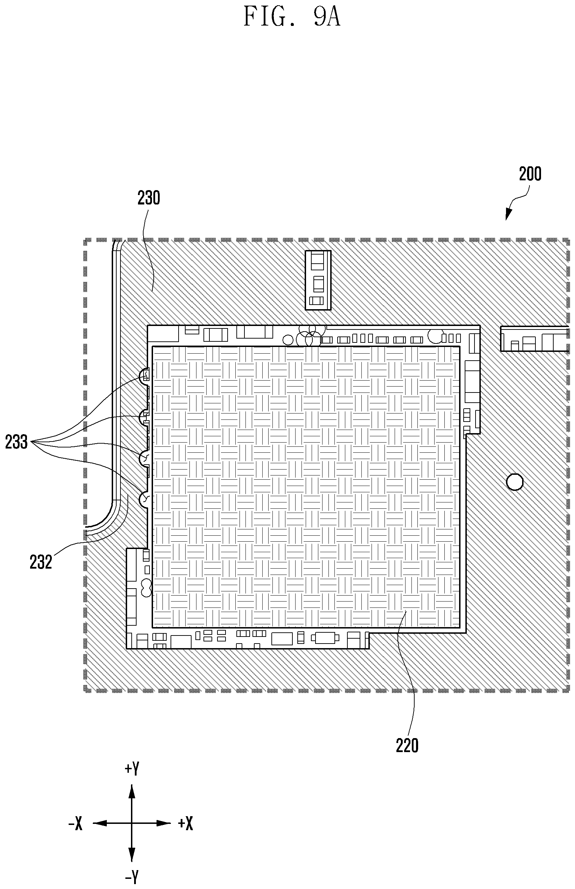

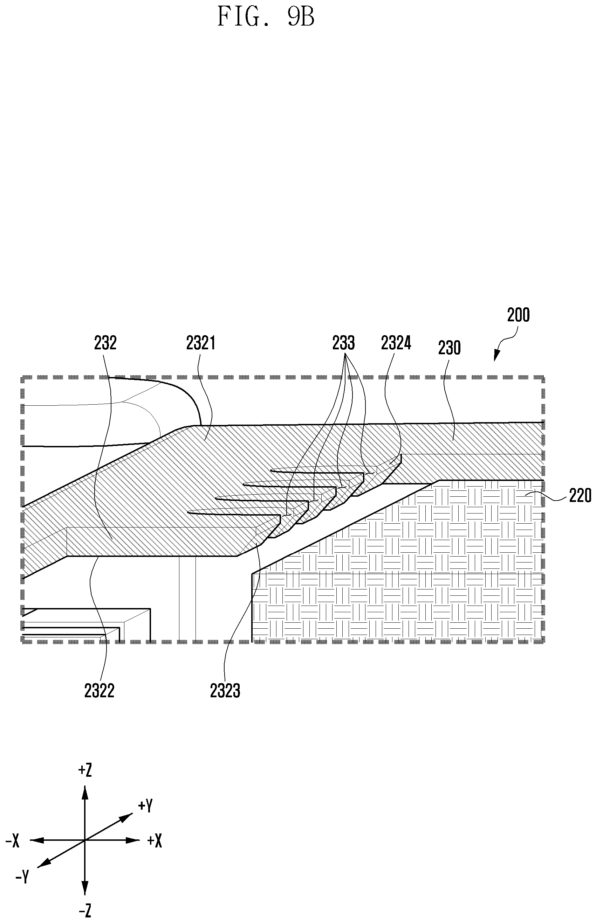

FIGS. 9A and 9B are views illustrating the shield frame 230 including the exhaust opening 233, according to an embodiment of the present disclosure.

In an embodiment, the shield frame 230 may include the exhaust opening 233 at least in part. For example, at least one exhaust opening 233 may be formed in the opening side area 232 of the shield frame 230.

In an embodiment, the exhaust opening 233 may be formed with a portion of the opening side area 232 having a recessed shape. The exhaust opening 233 may be formed with a portion of the opening side area 232 recessed in the length direction of the electronic device 200 (e.g., negative x-axis direction). The exhaust opening 233 may be formed by passing through the first surface 2321 of the opening side area 232 and the second surface 2322 of the opening side area 232.

In an embodiment, the exhaust opening 233 may be formed in a semicircular shape. For example, the exhaust opening 233 may have a semicircular shape formed with a diameter of approximately 0.8 mm or more.

With reference to FIGS. 9A and 9B, a plurality of exhaust openings 233 may be formed in the opening side area 232 of the shield frame 230. The plurality of exhaust openings 233 may be disposed at predetermined intervals along the width direction (e.g., y-axis direction) of the electronic device 200. For example, the plurality of exhaust openings 233 may be disposed spaced apart from each other along the width direction of the electronic device 200 by an interval of approximately 2 mm or more.

With reference to FIGS. 9A and 9B, the shield frame 230 is illustrated as including four exhaust openings 233, but the number of exhaust openings 233 that the shield frame 230 includes may not be limited thereto.

In an embodiment, a width of the exhaust opening 233 may mean a length that the exhaust opening 233 extends in the y-axis direction, and a length of the exhaust opening 233 may mean a length that the exhaust opening 233 extends in the x-axis direction.

In FIGS. 9A and 9B, each of the plurality of exhaust openings 233 is illustrated as having the same width and length formed, but this is exemplary and the width and length of each of the plurality of exhaust openings 233 may not be limited thereto. For example, the width of the exhaust opening 233 and the length of the exhaust opening 233 may be formed differently in each of the exhaust openings 233.

In an embodiment, the exhaust opening 233 may serve to allow the heat transfer material 250 (see FIG. 7D) to move easily in one direction of the electronic device 200. For example, the shielding sheet 240 (see FIG. 7D) may be disposed in the first direction of the heat transfer material 250 (see FIG. 7D) and at least a portion of the heat transfer material 250 (see FIG. 7D) may move toward the exhaust opening 233. A portion of the heat transfer material 250 (see FIG. 7D) that has moved toward the exhaust opening 233 may move from the exhaust opening 233 in the height direction of the electronic device 200 (e.g., negative z-axis direction). The heat transfer material 250 (see FIG. 7D) positioned in the exhaust opening 233 may move in the negative z-axis direction, and the heat transfer material 250 may be prevented from moving between the shielding sheet 240 (see FIG. 7D) and the shield frame 230.

In an embodiment, when the shield frame 230 includes the exhaust opening 233, the structural rigidity of the shield frame 230 may be maintained, and it may be easier for the heat transfer material 250 (see FIG. 7D) to move in a direction toward the printed circuit board 210 (see FIG. 7D) (negative z-axis direction).

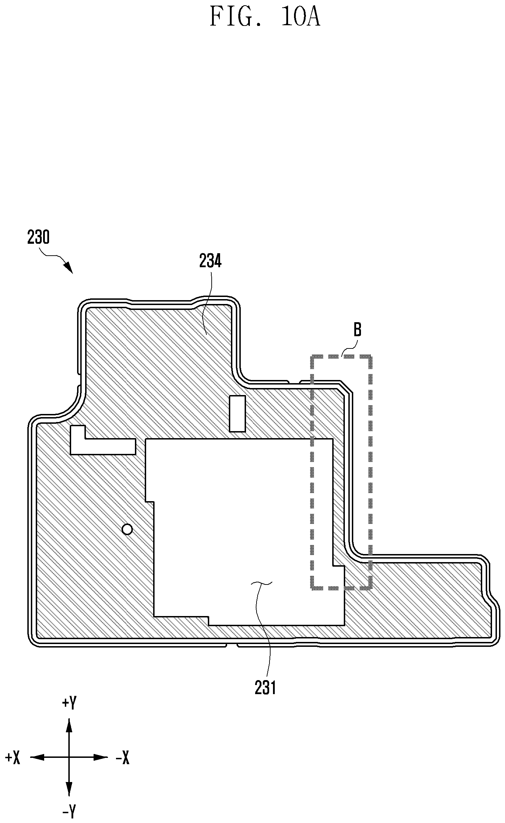

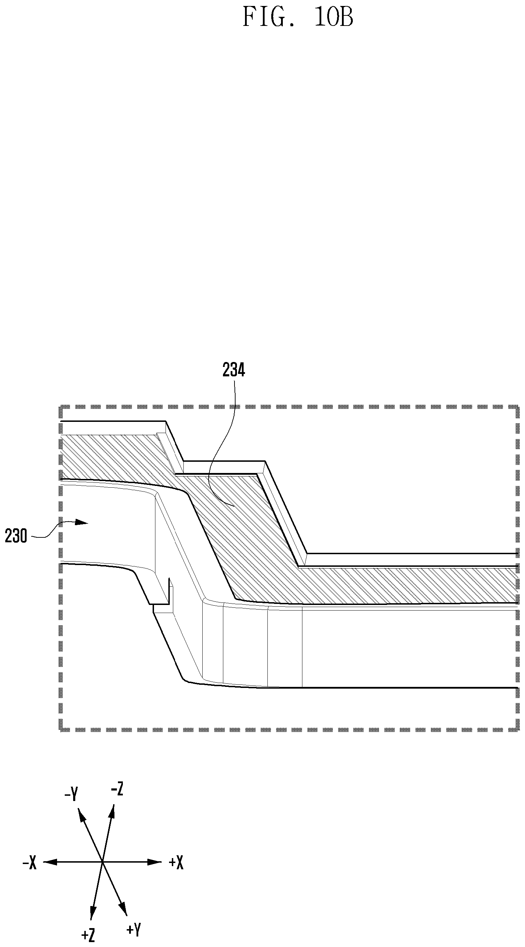

FIGS. 10A and 10B are views illustrating an insulating pad 234 disposed inside the shield frame 230, according to an embodiment of the present disclosure.

FIG. 10A is a view illustrating an interior of the shield frame 230, according to an embodiment of the present disclosure.

FIG. 10B is a view illustrating B area of an area of the shield frame 230 illustrated in FIG. 10A.

In an embodiment, the shield frame 230 may include the insulating pad 234 at least in part of the interior.

In an embodiment, the insulating pad 234 may include an insulating material for preventing shorts inside the shield frame 230 and an adhesive material for adhering the insulating pad 234 to the interior of the shield frame 230.

In an embodiment, the insulating pad 234 may be formed around the frame opening 231 of the shield frame 230 on the interior of the shield frame 230.

In an embodiment, the insulating pad 234 may further include an oil absorbing material capable of absorbing the oil material 252 (see FIG. 7D), which may serve to absorb the oil material 252 (see FIG. 7D) generated by the heat transfer material 250 (see FIG. 7D). After the heat transfer material 250 (see FIG. 7D) is disposed on one surface of the electronic component 220 (see FIG. 7D), the oil material 252 (see FIG. 7D) may be generated from the heat transfer material 250 (see FIG. 7D) and flow around the heat transfer material 250 (see FIG. 7D). The oil material 252 (see FIG. 7D) that flows around the heat transfer material 250 (see FIG. 7D) may be absorbed by the insulating pad 234 inside the shield frame 230.

Since the shield frame 230 according to the embodiment illustrated in FIGS. 10A and 10B includes the insulating pad 234, which has an oil absorbing function, on the interior, an overall thickness (e.g., a length in the z-axis direction) of the shield frame 230 and the pads (e.g., the insulating pad 234 and the absorbent pad 260 (see FIG. 5)) combined may be thinner compared to the shield frame 230 (see FIG. 5) having the absorbent pad 260 (see FIG. 5) disposed on the outside.

An electronic device according to an embodiment of the present disclosure may be one of various types of electronic devices. The electronic device may include, for example, a portable communication device (e.g., a smartphone), a computer device, a portable multimedia device, a portable medical device, a camera, a wearable device, or a home appliance. The electronic device according to the embodiment of the present disclosure is not limited to the above-mentioned devices.

An embodiment of the present disclosure and the terms used in the embodiment are not intended to limit the technical features disclosed in the present disclosure to the particular embodiments and should be understood as including various alterations, equivalents, or alternatives of the corresponding embodiments. In connection with the description of the drawings, the similar reference numerals may be used for the similar or relevant components. The singular form of a noun corresponding to an item may include one or plurality of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st" and "2nd," or "first" and "second" may be used to simply distinguish a corresponding component from another, and does not limit the components in other aspect (e.g., importance or order). When a constituent element (e.g., a first constituent element) is referred to, with or without the term "operatively" or "communicatively," as "coupled with," "coupled to," "connected with," or "connected to" another constituent element (e.g., a second constituent element), it means that the constituent element may be coupled with the other constituent element directly (e.g., wiredly), wirelessly, or via a third constituent element.

The term "module" used in an embodiment of the present disclosure may include a unit implemented in hardware, software, or firmware, and may interchangeably be used with other terms, for example, "logic," "logic block," "component," or "circuitry". A module may be a single integral component, or a minimum unit or part thereof, adapted to perform one or more functions. For example, according to an embodiment, the module may be implemented in a form of an application-specific integrated circuit (ASIC).

An embodiment as set forth herein may be implemented as software (e.g., the program 140) including one or more instructions that are stored in a storage medium (e.g., the internal memory 136 or the external memory 138) that is readable by a machine (e.g., the electronic device 101). For example, a processor (e.g., the processor 120) of the machine (e.g., the electronic device 101) may invoke and execute at least one of the one or more instructions stored in the storage medium. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to the embodiment, a method according to an embodiment of the present disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORETM), or between two user devices (e.g., smart phones) directly. In case of the distribution online, at least part of the computer program product may be temporarily generated or at least temporarily stored in the machine-readable storage medium, such as memory of the manufacturer's server, a server of the application store, or a relay server.

According to an embodiment, each constituent element (e.g., module or program), among the above-mentioned constituent elements, may include a single object or a plurality of objects, and some of the plurality of objects may be disposed separately in different constituent elements. According to an embodiment, one or more constituent elements, among the above-mentioned constituent elements, or operations may be omitted, or one or more other constituent elements or operations may be added. Alternatively or additionally, a plurality of constituent elements (e.g., modules or programs) may be integrated into a single constituent element. In this case, the integrated constituent element may perform one or more functions of each of the plurality of constituent elements in the same or similar manner as they are performed by a corresponding one of the plurality of constituent elements before the integration.

According to an embodiment, operations performed by the module, the program, or another constituent element may be executed sequentially, in parallel, repeatedly, or heuristically, or one or more of the operations may be executed in a different order or omitted, or one or more other operations may be added.

## Claims

1. An electronic device comprising:
a printed circuit board;
an electronic component disposed on one surface of the printed circuit board;
a shield frame disposed on one surface of the printed circuit board and surrounding the electronic component, and including a frame opening formed in a position corresponding to the electronic component;
a shielding sheet disposed on one surface of the shield frame, at least a portion of which is disposed in one direction of the frame opening of the shield frame to cover the frame opening; and
a heat transfer material disposed between the electronic component and the shielding sheet,
wherein the shield frame is formed on one side of the frame opening, and includes an opening side area including a first surface on which the shielding sheet is disposed and a second surface opposite the first surface, and
wherein, in the opening side area, the first surface of the opening side area is spaced apart from the electronic component by a first length in a length direction of the electronic device, and the second surface of the opening side area is spaced apart from the electronic component by a second length that is longer than the first length in a length direction of the electronic device.

2. The electronic device of claim 1, wherein the opening side area further includes a vertical surface that is a surface formed parallel to a height direction of the electronic device and perpendicular to a length direction of the electronic device, at least in part.

3. The electronic device of claim 1, wherein the opening side area further includes an inclined surface connected to the first surface of the opening side area at one end and connected to the second surface of the opening side area at the other end, and
wherein the inclined surface extends inclined by a predetermined angle in a direction toward the electronic component with respect to a height direction of the electronic device.

4. The electronic device of claim 3, wherein the inclined surface guides the heat transfer material to flow in a direction toward the printed circuit board.

5. The electronic device of claim 1, wherein the opening side area further includes:
a vertical surface that is a surface formed parallel to a height direction of the electronic device and perpendicular to a length direction of the electronic device, and connected to the first surface of the opening side area; and
an inclined surface connected to the vertical surface at one end and connected to the second surface of the opening side area at the other end, and
wherein the inclined surface extends inclined by a predetermined angle in a direction toward the electronic component with respect to a height direction of the electronic device.

6. The electronic device of claim 5, wherein the vertical surface has a third length in the height direction of the electronic device, and the inclined surface has a fourth length in the height direction of the electronic device, and
wherein the third length is formed shorter than the fourth length.

7. The electronic device of claim 1, wherein the heat transfer material includes a GEL TIM.

8. The electronic device of claim 1, wherein the heat transfer material includes a diffusion area that is, at least in part, in contact with the opening side area and moves in a direction toward the printed circuit board.

9. The electronic device of claim 8, wherein the diffusion area is moved in a direction toward the printed circuit board by the shield frame and the shielding sheet.

10. The electronic device of claim 1, further comprising:
an absorbent pad disposed on the second surface of the opening side area.

11. The electronic device of claim 10, wherein at least a portion of an oil material discharged from the heat transfer material moves in a direction toward the absorbent pad and is absorbed by the absorbent pad.

12. The electronic device of claim 1, wherein the shield frame includes an insulating pad including an insulating material, an adhesive material, and an oil absorbing material at least in part therein.

13. The electronic device of claim 1, wherein the opening side area includes an exhaust opening having a shape in which a portion of the opening side area is recessed and formed by passing through the first surface of the opening side area and the second surface of the opening side area.

14. The electronic device of claim 13, wherein the opening side area includes a plurality of exhaust openings, the plurality of exhaust openings being disposed at predetermined intervals from each other along a width direction of the electronic device.

15. The electronic device of claim 1, wherein the electronic component is an application processor.
